# EUROPEAN PATENT APPLICATION

(11) **EP 4 663 315 A1**
(43) Date of publication of application: **17.12.2025**
(21) Application number: 25182308.4
(22) Date of filing: 12.06.2025
(51) Int. Cl.: B09B 3/30, H10F 19/80

(54) **MACHINE FOR REMOVING A FRAME OF A PHOTOVOLTAIC PANEL**

(30) Priority: 12.06.2024 IT 202400013447
(71) Applicant: HIRO Robotics S.r.l., 16121 Genova (GE) (IT)
(72) Inventor: Labolani, Davide, 16121 Genova (GE) (IT); Olivieri, Michele, 16121 Genova (GE) (IT); Toccafondi, Leonardo, 16121 Genova (GE) (IT)
(74) Representative: Bottino, Giovanni

(57) **Abstract**

Machine for removing a frame (11) from a photovoltaic panel (1), which panel (1) comprises a main body (10) and a frame (11) fixed perimetrically to the main body (10), comprising support means adapted to hold the panel (1) in a frame-removing position and frame-removing means (3) configured to press on part of the frame (11) when the panel (1) is held by the support means until causing the frame (11) to be removed from the main body (10). The frame-removing means (3) are configured to act on two mutually opposite sides of said frame (11) and the support means comprise a gripping device (4) driven by drive means, which gripping device (4) is movable at least away from and towards the frame-removing means (3) and is rotatable at least around an axis perpendicular to the face of the panel (1) and is provided with a plurality of suction gripping members (5).

## Description

The present invention falls within the technical field related to photovoltaic or solar panels, in particular it refers to the automated removal of a perimeter frame of a photovoltaic panel.

The invention relates to a machine for removing a perimeter frame of a photovoltaic panel, which photovoltaic panel comprises a main body and a perimeter frame fixed perimetrically to the main body. The machine comprises support means adapted to hold the photovoltaic panel in a frame-removing position and frame-removing means which are configured to press on part of the perimeter frame when the photovoltaic panel is held by the support means until causing the frame to be removed from the main body.

As is known, a photovoltaic panel, once assembled, generally comprises:
- a glass protective layer;
- a first protective layer in plastic material (generally ethylene vinyl acetate, EVA) arranged below the glass protective layer;
- a plurality of photovoltaic cells, arranged below the first protective layer in plastic material, each comprising a silicon sheet (in some cases enriched with elements such as gallium, tellurium and cadmium) and electrical circuits;
- a second protective layer in plastic material (EVA) arranged below the photovoltaic cells;
- a third protective layer in plastic material, known in the sector as "backsheet" (for example, a layer in polyvinylfluoride, also known as "Tedlar") which constitutes the bottom of the photovoltaic panel and which is arranged below the second layer in plastic material;
- an aluminium perimeter frame that surrounds the aforementioned layers perimetrically and is fixed to them by means of glue, rivets and/or folding by pressure on the glass.

Through the perimeter frame it is possible to hook the photovoltaic panel to support structures suitable for supporting it and orienting it appropriately towards the sun, when for example it is arranged on a roof. In addition, the perimeter frame gives mechanical strength to the photovoltaic panel, in particular to mechanical loads such as snow or wind. Additionally, the perimeter frame allows the photovoltaic panel to be easily handled and stored.

In the event that a photovoltaic panel must be replaced (for example because it is damaged or has reached the end of its useful life), it is possible to proceed with its disassembly, i.e. the removal of the perimeter frame from the main body of the photovoltaic panel and the removal of the different layers that make up the main body, to allow the recovery of the raw materials present in the photovoltaic panel. For the subsequent recovery operations of the raw materials present in the photovoltaic panel, it is preferable for the main body of the photovoltaic panel to be substantially intact, so that it is possible to maximize the recovery efficiency of the raw materials of the disassembly system.

The process of treating an end-of-life photovoltaic panel involves, prior to the recovery of the glass and other components, the removal of the aluminium frame and junction box, i.e. an electrical connection box fixed to the back of the panel, unless the panel is shredded in its entirety. Recovering aluminium in intact bars, rather than shredded, allows it to be marketed at higher prices.

To date, the perimeter frame is typically removed from the main body of the photovoltaic panel manually, by means of a hammer. In particular, by means of a hammer one acts with force on different points of the perimeter frame, causing the detachment of the perimeter frame from the main body and the crushing of some areas of the upper layer of the main body, especially in the areas in contact with the points of the perimeter frame on which the hammer acts. Such a manner of removing the perimeter frame could lead to crushing of part of some layers of the main body and requires long processing time.

For these reasons, automated equipment has been implemented to dismount the frame of the photovoltaic panels, in order to reduce the use of human resources. However, such devices have defects such as deformations of the aluminium frame during the removal process, requiring manual supervision and reducing the efficiency of the automated production line.

Document CN116441899A describes an automatic frame removal plant for recycling photovoltaic panels. The plant comprises a supply device, a disassembly device body and an unloading device. The body of the disassembly device comprises a rack body and two opposing frame locking mechanisms disposed on the rack body. Each frame locking mechanism comprises a sliding beam on which an unloading device is arranged. A fixing mechanism used for fixing a photovoltaic panel is arranged centrally and comprises an upper spindle and a lower spindle acting on the photovoltaic panel so that the frame can be locked and then removed by pulling.

Document KR20230022678A describes a system for removing the frame from a photovoltaic panel that acts by applying a force through pulling or pushing operations, after heating the adhesive part that fixes the frame to the photovoltaic module. The frame-removing device is composed of a lifting actuator that lifts and fixes the photovoltaic module on an upper plate, while a heater is used to heat the adhesive part that fixes the frame to the module. A hook bracket then separates the frame by pulling or pushing operations. The device includes a rotating actuator that allows the photovoltaic module to be rotated, facilitating the removal of the frame on all sides.

Document CN117718306A describes a machine for removing the frame of photovoltaic panels. The machine is equipped with a shredder to reduce the removed frames to fragments and solve the problem of their overall dimensions. The machine operates with two frame-removing grippers that act on two opposite sides of the panel. The panel is moved and then held pressed on a support seat by a gripping head provided with suction cups supported by the frame and driven towards/away from a piston and in rotation by a motor.

Document CN108393329A discloses an apparatus for recycling decommissioned solar photovoltaic components. Such apparatus comprises a base plate, a material load case, a material transport device, and a frame removal device. The frame of panel is removed two sides at a time by blades. A cylinder with end suction cup is used to position the panel in height and rotate it 90° after the action of the blades 4 on the first pair of sides. The retention of the panel during frame-removal is not carried out by the cylinder with suction cup but by a pair of holding grippers that grasp the panel on the other two sides with respect to those on which the blades act.

These currently known systems, however, have certain limitations. First of all, the frame is dismembered into bars, which however are not often removed individually, resulting in "L" shapes that are difficult to store. Even more important is the high occurrence of glass damage: removal of the bars often results in detachment of parts of the glass from the panel, especially when the frame is pressed, thus significantly reducing the value of the recovered aluminium. Finally, the speed of the process is not satisfactory, given that it is well over 60 seconds for each operation, when industrial needs would require it to be below these times.

Therefore, there is a need in the state of the art for a system for removing the perimeter frame of photovoltaic panels that overcomes these disadvantages of currently known systems and improves the efficiency of the disassembly process. In particular, it is wished to obtain a clear separation of the bars that make up the frame from the main body, their separation from the main body without glass residues, an increased speed of the entire process.

The invention aims at achieve the above objects and to overcome the drawbacks of the currently known systems with a machine as described at the beginning, wherein furthermore the frame-removing means are configured to act on two mutually opposite sides of said frame and the support means comprise a gripping device driven by drive means, which gripping device is movable at least away from and towards the frame-removing means and is rotatable at least about an axis perpendicular to the face of the panel and is provided with a plurality of suction gripping members.

The action on two opposite sides of the frame ensures a uniform and balanced removal, reducing the risk of damage or deformation. The movements carried out by the gripping device allow the panel to be positioned and held quickly so that the frame-removing means act first on the first two sides of the frame and then on the further two sides. In these operations, the suction gripping members guarantee a safe and stable grip of the panel, while allowing firm retention and fast handling. The firm grip guarantees a decrease in the vibrations of the panel during the action of the frame-removing means and therefore, in addition to allowing a faster operation, it minimizes the risk of detaching fragments of glass that may remain coupled to the bars resulting from the disassembly of the frame.

In an exemplary embodiment, the support means comprise a mechanical arm, and the gripping device consists of a gripping head of said mechanical arm.

The use of a mechanical arm as a support means offers the great advantage of carrying out with a single device both the enslavement of the panel to the frame-removing means, i.e. its delivery, and holding of the panel in position during the action of the frame-removing means, and potentially its removal. This allows the machine to be inserted as a station in a disposal line, in which the panels are fed in, for example by an inlet conveyor belt, and withdrawn at the outlet, for example by an outlet conveyor belt. The mechanical arm can enclose in a single device the functions of withdrawing from the inlet, transporting to the frame-removing position, holding the panel during frame-removal and transporting the panel without frame to the outlet and release. The gripping head integrated in the mechanical arm also allows precise and controlled movements and the flexibility of the mechanical arm makes it possible to easily reach different positions and angles, adapting to various dimensions and shapes of the photovoltaic panels. This configuration reduces the time required for the frame-removal process and increases operational efficiency, while maintaining stability and safety when handling the panel.

According to a further embodiment, each suction gripping member grips a respective gripping portion on the photovoltaic panel and comprises an adjustable pusher element configured to adjustably push said photovoltaic panel portion.

The inclusion of independent pusher elements for each suction gripping member allows different forces to be applied at specific points on the panel, improving the precision of the frame-removal process. This approach reduces the risk of damaging the photovoltaic cells, limiting the phenomenon of tearing the cells together with the aluminium of the frame. In addition, the adjustability of the pusher elements allows the pressure exerted to be adapted based on the specific needs of the panel, optimising the effectiveness of the removal of the frame for different panels. The presence of a plurality of suction gripping members provided with pusher elements allows an even distribution of the gripping forces on the panel, increasing stability during the frame-removal process. This improves operational safety and allows panels of different dimensions or with localised deformations to be treated. In addition, the functional redundancy of the gripping members guarantees greater reliability of the system, allowing maintaining operational efficiency even in the event of partial loss of adhesion of one of the members.

In a further embodiment, each pusher element is actuatable independently with respect to the other pusher elements and is configured to exert an autonomously adjustable pressure.

This configuration allows differentiated forces to be applied at specific points on the photovoltaic panel, significantly improving the precision and efficiency of the frame-removal process.

The independent implementation of the pushers allows the pressure exerted to be locally adapted as a function of the characteristics of the panel, such as any deformations, structural irregularities, or different mechanical strengths along the edges.

In addition, the autonomous adjustment of the pressure for each pusher allows a fine control of the process, improving the quality of the operation and increasing operational safety. The configuration described also offers high flexibility, being suitable for the processing of panels of different types, dimensions or state of preservation. In the event of a malfunction of a single pusher, the others can continue to operate regularly, ensuring the continuity of the process and reducing machine downtime.

The pusher elements that are actuatable independently and with autonomously adjustable pressure can be made, for example, by means of electric linear actuators controlled individually by an electronic system (such as a PLC), pneumatic cylinders managed by proportional valves or dedicated solenoid valves, electromechanical actuators with integrated force sensors for feedback control, hydraulic pistons inserted in multichannel circuits with electronic pressure regulation, or motorized screw systems driven by torque-controlled servomotors.

According to an exemplary embodiment, a panel dimensional analysis module is comprised.

This module allows the dimensions of the panel to be accurately measured, ensuring that the frame remover can adapt and operate optimally on panels of different dimensions and reducing the need for manual interventions.

According to a further embodiment, the dimensional analysis module comprises one or more cameras.

This enables the images of the photovoltaic panel to be acquired, providing accurate and detailed data on its dimensions and characteristics. This aspect allows an accurate and real-time measurement, improving the adaptability of the machine to panels of different dimensions and reducing the margin of error. In addition, the use of cameras may allow the identification of any defects or irregularities in the panel.

According to an exemplary embodiment, said gripping members are provided movable on the gripping device and the gripping device is provided with means for moving the gripping members.

This allows a dynamic adaptation to the different shapes and dimensions of the photovoltaic panels, ensuring an optimal grip on each portion of the panel. The means for moving the gripping members ensure that the grip on the panel adapts to its dimensions to offer always optimal retention. This flexibility reduces the risk of damage when handling the panel, improving the quality of the recycled panel, and helps to reduce setup time and simplify the process of adapting the machine to different types of panels, making the system more versatile.

According to a further embodiment, the means for moving the gripping members are configured to move the gripping members as close as possible to the edges or corners of the photovoltaic panel on the basis of the dimensions detected by said photovoltaic panel dimensional analysis module.

The possibility of moving the gripping members in length and width allows them to adapt precisely to the dimensions of the photovoltaic panel, ensuring an optimal grip. By positioning the gripping members as close as possible to the corner areas and edges of the panel, greater stability is ensured during the frame-removal process, limiting vibrations and movements that could lead to glass breakage and therefore not optimal frame separation. This dynamic adaptation to the specific dimensions of the panel also facilitates the treatment of panels of different dimensions without the need for frequent manual adjustments.

According to one embodiment, the frame-removing means are configured to be positioned preliminarily on the basis of the dimensions detected by said photovoltaic panel dimensional analysis module.

By allowing the frame-removing means to position itself automatically based on the detected dimensions of the photovoltaic panel, the frame-removal process is significantly speeded up.

According to a further embodiment, said frame-removing means are configured to adjust their excursion on the basis of the dimensions detected by said photovoltaic panel dimensional analysis module.

The ability of the frame-removing means to adjust their excursion according to the precise dimensions of the photovoltaic panel allows an adaptation to the specific needs of each panel. This optimizes the pressure applied during the frame-removal process, reducing the risk of damage to the photovoltaic cells, and improves the speed and precision of the process.

In an exemplary embodiment, the frame-removing means comprise blades of contact with said frame, which blades have a sharp engagement end edge and an intermediate thrust surface and are tiltable in a direction away from the surface of the panel in such a way that, during the action of the pusher means, the blades carry out a prior insertion into the slot between the frame and the main body by means of the sharp engagement end edge and a subsequent thrust by means of said intermediate thrust surface.

The blades of contact with a sharp end edge allow a precise and rapid insertion into the slot between the frame and the main body of the panel, ensuring an effective engagement on the frame and at the same time reducing the risk of damage to the panel itself. The intermediate thrust surface provides a uniform force, ensuring effective frame removal.

According to an exemplary embodiment, the support means comprise an abutment plate consisting of a plurality of movable sectors driven independently of each other in such a way as to form two alternative configurations adapted to maximize the area of contact of the abutment plate with the panel in orientations of the panel perpendicular to each other.

The presence of movable sectors driven independently allows the abutment plate to be adapted to different dimensions and orientations of the photovoltaic panel, guaranteeing optimal contact at each step of frame-removal. The two alternative configurations ensure that the area of contact is maximized, in each orientation of the panel, improving stability and precision during the frame-removal process. This dynamic adaptation reduces the risk of damage and ensures that the panel is always firmly held in position during the action of the frame-removing means. In addition, the ability to independently adjust each movable sector facilitates operation on panels of different shapes and dimensions, for increased versatility.

An object of the present invention is also a method for removing a frame from a photovoltaic panel, which panel comprises a main body and a frame fixed perimetrically to the main body, comprising the following steps:
a) withdrawing said panel by a mechanical arm provided with a gripping head comprising suction gripping members;
b) positioning of the panel near frame-removing means by the mechanical arm;
c) simultaneous holding by said mechanical arm in position of the panel and actuation of the frame-removing means.

In an exemplary embodiment, each suction gripping member grips a respective gripping portion on the panel and comprises an adjustable pusher element configured to adjustably push said panel portion.

In a further embodiment, each pusher element is actuatable independently with respect to the other pusher elements and is configured to exert an autonomously adjustable pressure.

In a further embodiment, said suction gripping members are provided movable on the gripping device. The gripping members can then be moved, preferably before step a).

In a further embodiment, prior to step a), a panel dimensional analysis step is performed and said suction gripping members are moved as close as possible to the edges or corners of the panel on the basis of the dimensions detected in said panel dimensional analysis step.

In a further exemplary embodiment, prior to step a) a panel dimensional analysis step is performed and the frame-removing means are positioned on the basis of the dimensions detected in said panel dimensional analysis step and/or to adjust their excursion on the basis of the dimensions detected in said panel dimensional analysis step.

In an exemplary embodiment, the method can be implemented by a machine as described above.

These and other features and advantages of the present invention will become clearer from the following disclosure of some exemplary embodiments illustrated in the accompanying drawings, wherein:
fig. 1 illustrates an overall view of the machine;
figs 2 and 3 illustrate different views of the gripping device;
fig. 4 illustrates the frame-removing means;
figures 5, 6 and 7 illustrate different views of the blades in contact with the frame.

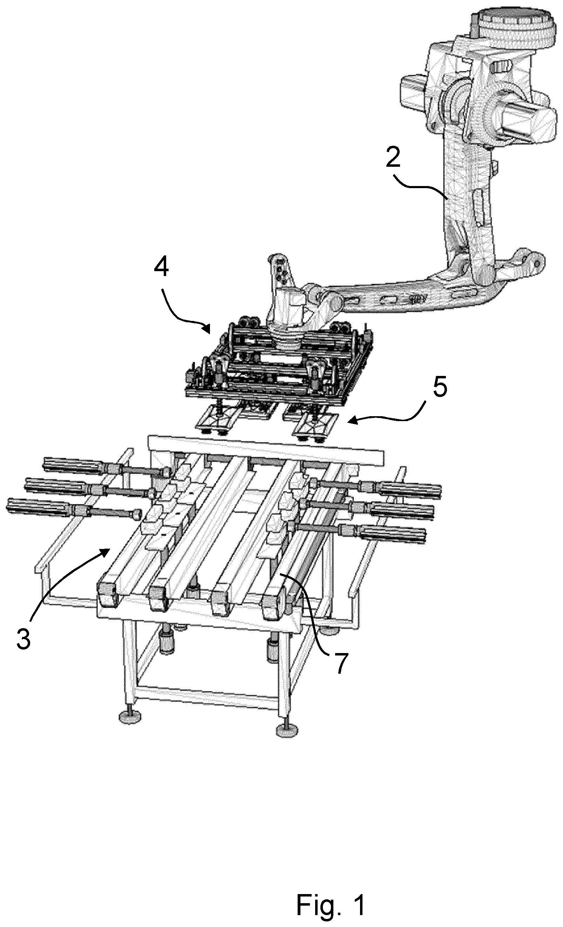

Figure 1 illustrates an exemplary embodiment of the machine for removing a frame 11 of a photovoltaic panel 1 according to the present invention.

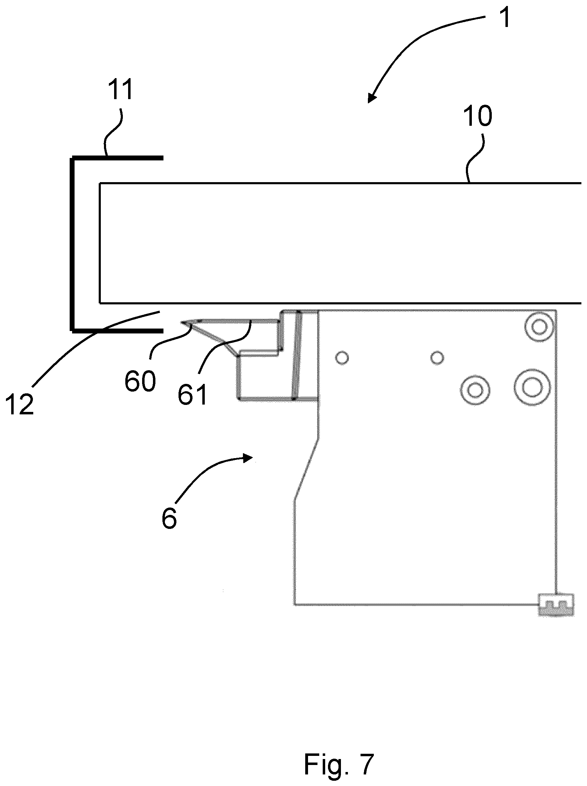

The panel 1, as illustrated in figure 7, comprises a main body 10 and a frame 11 fixed perimetrically to the main body 10. The frame 11 is typically rectangular in shape, with two longer sides and two shorter sides. The frame 11 is typically made of metal, in particular aluminium or aluminium alloys.

The machine comprises support means adapted to hold the panel 1 in a frame-removing position and frame-removing means 3 configured to press on part of the frame 11 when the panel 1 is held by the support means until determining the removal of the frame 11 from the main body 10.

The support means comprise a gripping device 4 driven by drive means. The gripping device 4 is movable at least away from and towards the frame-removing means 3 and is rotatable at least about an axis perpendicular to the face of the panel 1. The gripping device 4 is provided with a plurality of suction gripping members 5. The gripping device 4 is adapted to hold the panel in the frame-removing position when the frame-removing means 3 are driven.

The frame-removing means 3 are configured to act on two mutually opposite sides of the frame 11, and therefore constitute a tear-off mechanism on two sides of the frame.

The rotatable gripping device 4 therefore rotates the panel 90 degrees to remove the frame on all four sides.

In the preferred embodiment illustrated in the figures, the support means comprise a mechanical arm 2, which constitutes said drive means, and the gripping device 4 consists of a gripping head of the mechanical arm 2. The mechanical arm 2 can be of any type, preferably it is a six-axis anthropomorphic robot hanging from a carpentry structure of the machine, so as to be positioned above the frame-removing means 3. The mechanical arm 2 holds the panel 1 in position during frame-removal. The mechanical arm 2 also takes care of the rotation of the panel 1 by 90 degrees in the two consecutive frame-removing steps.

The mechanical arm 2 preferably also takes care of the enslavement of the panels 1 to the frame-removing means 3. The machine comprises an unloading belt carpet 7, which is responsible for unloading the main body 10 of the panel 1 without the frame 11.

A gripping device 4 not constrained to a mechanical arm 2 but driven by other drive means may be provided. In particular, it is possible to provide a mechanism configured to replicate the work done by the gripping head and by the last joint of the mechanical arm 2. Such a mechanism, placed above the belt carpet 7, is preferably composed of a plurality of linear actuators, for example pneumatic or electric pistons, placed in such a way as to push downwards, each being actuated independently of the others. Plates coated with a friction-creating material, for example elastomer, may be provided at the end of such actuators. This set of pistons is coupled to a rotatable plate that replicates the movement of the last joint of the mechanical arm 2 to allow the removal of the frame of all four sides of the frame 11.

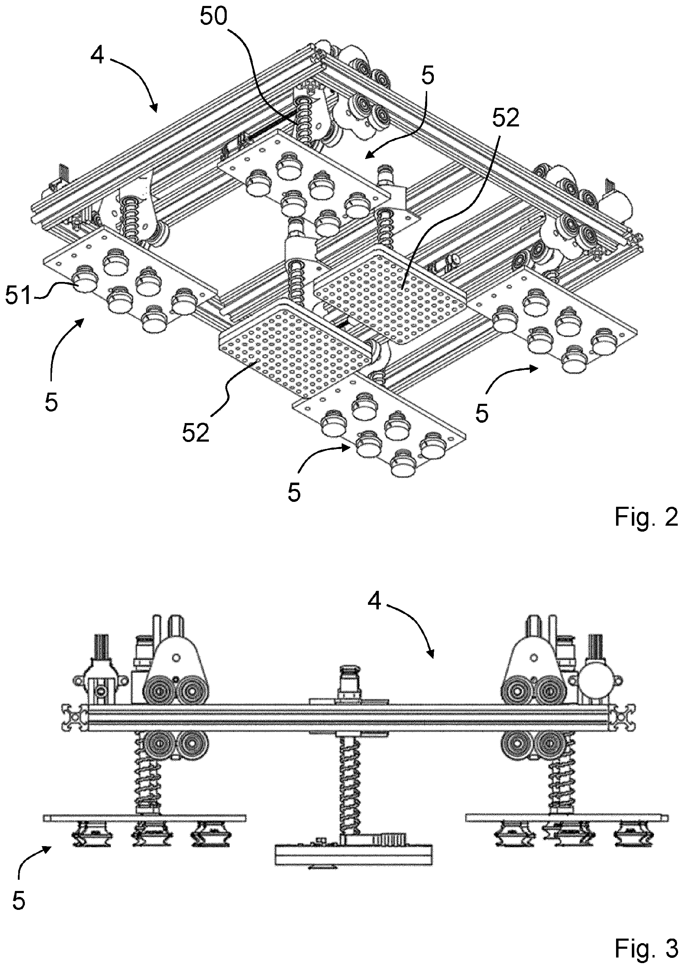

Figures 2 and 3 illustrate two views of the gripping device 4, in particular consisting of a gripping head 4 of the mechanical arm 2.

The mechanical arm 2 is provided with a gripping head 4 provided with suction gripping members 5, in particular composed of several suction cups 51, sponge suction systems, or other vacuum retention systems. Each suction gripping member 5 is adapted to grip a respective gripping portion on the panel 1 and comprises an adjustable pusher element 50 or piston configured to adjustably push said panel portion 1. In the example of the figures, each suction gripping member 5 comprises six suction cups 51. The pusher element 50 may comprise one or more springs and/or an active drive system.

This gripping head 4 allows different forces to be applied at different points of the panel 1, limiting the phenomenon of tearing off part of the photovoltaic cells together with the aluminium of the frame 1.

The figures show four suction gripping members 5, each consisting of a plate provided with six suction cups 51, responsible for gripping the photovoltaic panel 1. For each suction gripping member 5, the plate is fixed to a piston 50 that has both a shock absorber or spring to retract when it comes into contact with the surface of the panel, so that the four pistons once in contact bring the four plates to match the plane of the panel 1, and an actuation mechanism that, as described above, makes it possible to push with different force in the different portions of the panel 1 to minimize the risk of breakage.

In addition, the suction gripping members 5 are provided movable on the gripping device 4, and the gripping device 4 is provided with means for moving the suction gripping members 5. In particular, there are tracks in which each suction gripping member 5 can slide in an actuated manner, so that the four suction gripping members 5 adapt to the dimensions of the panel 1.

In the central position of the gripping device 4 there are two vacuum generation systems 52 that are used for gripping the pallet on which the stack of panels 1 originally rests, this gripping being carried out once the stack is depleted and it is necessary to move the pallet. The vacuum generation systems 52 are preferably sponge systems and are also fixed to an actuated piston with damper, through which piston they are exposed when they are ready for use or retracted when not in use. The choice between suction cups and sponges is dictated by the fact that the suction cups optimize air consumption compared to the sponge and were therefore preferred in the case of panel 1, while they would be less effective in the case of the pallet. In both cases, however, both sponge elements and suction cups can be used.

Preferably, the machine comprises an electronic control unit and a panel 1 dimensional analysis module connected to the electronic control unit, in particular a visual analysis module provided with one or more cameras, not illustrated in the figures.

The means for moving the suction gripping members 5 are preferably configured to move the suction gripping members 5 as close as possible to the edges or corners of the panel 1 on the basis of the dimensions detected by said panel 1 dimensional analysis module.

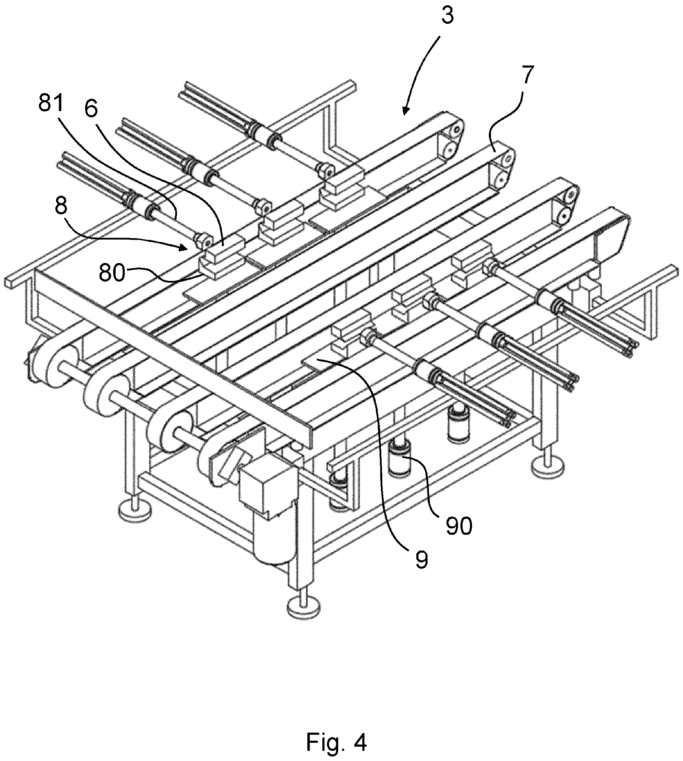

Figure 4 illustrates in detail the frame-removing means 3, configured to act on two mutually opposite sides of the frame 11 of the panel 1. The frame-removing means constitute a tear-off mechanism operating on both sides of the panel 1. The mechanical arm 2 is responsible for rotating the panel by 90 degrees, by means of its own end joint, thus allowing in two steps access to all sides of the panel 1 by the frame-removing means 3, for a complete removal of the frame.

The machine also comprises a hopper and a recovery belt for the removed aluminium bars, although these components are not illustrated in the figures.

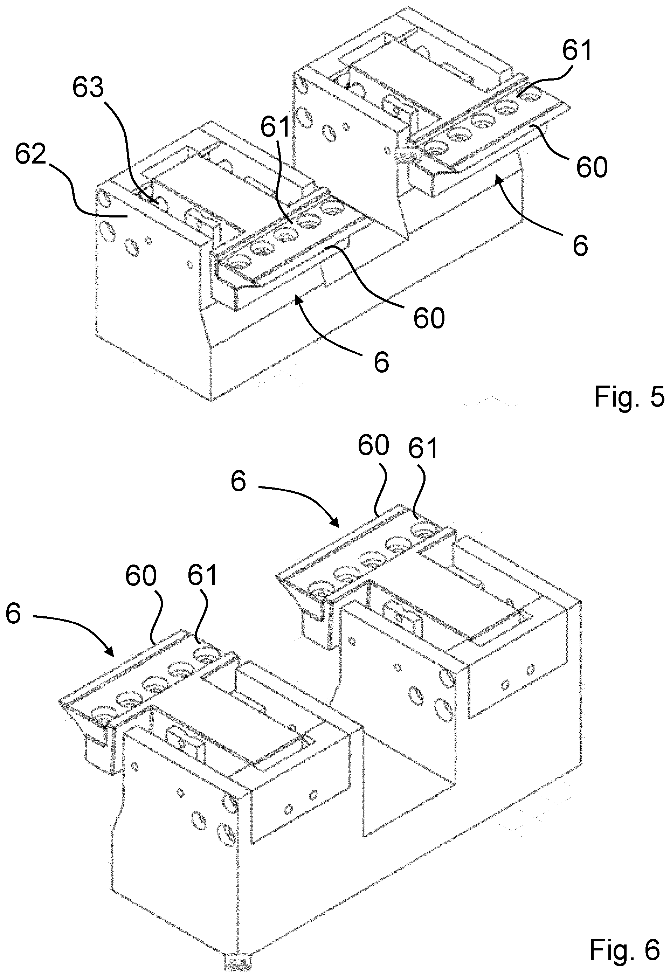

The frame-removing means comprise elements of engagement with the frame 11, each engagement element being composed of two distinct blade blocks. The upper block 6, described in detail in figures 5, 6 and 7, comes into contact with the front side of the panel 1, while the lower block 80 acts as an abutment and rests against the frame part 11 that extends perpendicularly to the rear side of the panel 1, aiding in tearing it off. The two blocks 6 and 80 are equipped with an actuation system that allows them to open and close in order to grasp the panel 1 before starting to pull.

The blade blocks 6 and 80 are driven by pistons 81, which retract to tear the frame 11 off and extend before grasping the panel 1, carrying out the operating excursion of the frame-removing means. In total, in the example in the figure, there are three engagement elements per side, each provided with a respective piston 81.

As always illustrated in figure 4, the support means comprise an abutment plate consisting of a plurality of movable sectors 9 driven independently from each other in such a way as to form two alternative configurations adapted to maximize the area of contact of the abutment plate with the panel 1 in orientations of the panel 1 perpendicular to each other. In particular, the movable sectors 9 are made up of two or more plate-shaped elements driven by two or more pistons 90 and placed under the belt carpet 7. The movable sectors 9 act as an abutment for the thrust exerted by the gripping device 4. These pistons 90 are activated depending on the direction of orientation of the panel 1 during the two frame-removal steps. This makes it possible to press against a surface of the panel 1 as wide as possible.

In the example in the figure, six movable sectors 9 are provided, three per side, which are fixed to retractable pistons 90. These movable sectors 9 constitute the abutment plate adapted to exert a thrust to hold the panel 1 stationary during the frame-removal process. The number of the movable sectors 9 activated varies based on the dimensions of the panel 1 detected by the dimensional analysis module.

The frame-removing means 3 are configured to position themselves preliminarily on the basis of the dimensions of the panel 1 detected by the dimensional analysis module and/or to adjust their excursion on the basis of the dimensions detected by the same analysis module.

Figures 5, 6 and 7 illustrate the frame-removing means 3, which comprise said upper blocks 6. These upper blocks constitute blades of contact 6 with the frame 11 of the panel 1. The blades 6 have a sharp engagement end edge 60 and an intermediate thrust surface 61. These blades 6 are designed to be tiltable away from the surface of the panel 1. During the action of the frame-removing means 3, the blades 6 carry out a preliminary insertion into the slot 12 between the frame 11 and the main body 10 of the panel 1, using the sharpened engagement end edge 60, and then carry out a thrust through the intermediate thrust surface 61.

These blades 6 are in fact mounted in an outer casing 62 in an oscillating manner around a pin 63, in such a way that they have a few degrees' clearance that allows them to tilt guided at the time of contact with the surface to be separated. This system is designed to use blades 6 provided with a sharp engagement end edge 60 as thin as possible to fit into the frame 11, but without cutting at the time of pushing. On the contrary, by leveraging with the upper part of the blade, i.e. with the intermediate thrust surface 61, the blades 6 merely tear away the aluminium. This approach aims to minimize or zero, together with the other solutions already mentioned, the glass parts that remain attached to the aluminium bars resulting from the frame 11. This conformation in fact ensures that the blades 6 are thin enough to easily enter the slot 12, but strong enough to tear away the aluminium without causing excessive damage to the glass or cells of the panel 1.

The following describes the operation of the machine for implementing the method of removing a frame 11 of a photovoltaic panel 1 according to the present invention.

The method provides for withdrawing a panel 1 by a mechanical arm 2 provided with a gripping head 4 comprising suction gripping members 5, positioning the panel 1 near frame-removing means 3 by the mechanical arm 2, at the same time holding by the mechanical arm 2 in position of the panel 1 and the actuation of the frame-removing means 3.

Finally, it is possible to remove the panel 1 by the frame-removing means 3 by the mechanical arm 2. Alternatively, the main body 10 of the panel 1 without the frame 11 is unloaded by the belt conveyor carpet 7.

The photovoltaic panels 1 can arrive at the withdrawal area of the mechanical arm 2 or superimposed in a stack in a pallet or singularised through a conveyor belt. In both cases, a dimensional analysis of the photovoltaic panel is performed by means of a 3D camera or laser scanner that acquires three-dimensional information. This information is then used to optimize the process for removing the aluminium frame 11 by adjusting, for example, the excursion of the tear-off cylinders 81 or by pre-positioning the cylinders 81 to a suitable initial position even before the panel 1 is positioned on the frame-removing means 3, so as to reduce the cycle time.

Subsequently, a control of the panel 1 is carried out by means of a 2D camera to verify the orientation of the panel 1 and, if necessary, its type. Once the panel 1 arrives in the area of the mechanical arm 2, it is grasped by the gripping head 4 of the mechanical arm 2. The mechanical arm 2 may be installed or suspended on a carpentry structure, or positioned laterally to the frame-removing machine. The gripping head 4 of the mechanical arm 2 comprises four suction gripping members 5, movable both in a direction perpendicular to the plane of the gripping head 4, and in a longitudinal direction. The suction gripping members 5 may have suction cups 51 to minimize air consumption or micro-hole sponges as ends. The gripping head 4 is also provided with two pneumatic central plates 52 with end sponges for handling the pallets on which the panels 1 are stacked. Each suction gripping member 5 is driven by an electric or pneumatic piston and has one or two shock absorbers, allowing pressure to be applied to different areas of the panel 1 with different forces, which is crucial during the steps for removing the frame.

If the panel 1 is withdrawn by the mechanical arm 2 with the glass surface facing downwards, the mechanical arm 2 positions it on a carpentry structure consisting of two parallel crosspieces, placed at such a height that the mechanical arm 2 can rest the panel 1 on it and, at the same time, grasps it again on the other side by positioning itself under the two crosspieces. This method allows the mechanical arm 2 to quickly change the gripping side of the panel 1.

Once it is certain that the panel 1 is grasped by the mechanical arm 2 from the glass surface, the mechanical arm 2 places it on a support structure under which two 2D cameras pointed upwards are fixed. These cameras acquire an image of the rear surface of the panel, identifying the junction boxes (cable connection boxes). Once the junction box has been located with respect to the frame 11 of the panel 1, the mechanical arm 2, while keeping the panel 1 stably constrained to itself, moves it to bring the junction boxes, one after the other, at a cutting system composed of two blades. These blades, placed in contact with the back of the panel 1, slide against each other to detach the junction box, which is held by glues or silicone.

After removing the junction box, the mechanical arm 2 positions the panel 1 inside the frame-removal station, i.e. near the frame-removing means 3. The frame-removal station is also equipped with a belt carpet 7 that carries the panels 1 out of the machine once the frame thereof has been removed.

The lower abutment plate that helps to hold the panel 1 in position during the removal of the frame is made up of two or more pistons 90 below the belt carpet 7 and two or more different movable abutment sectors 9, driven by said pistons 90 and activated depending on the orientation of the panel 1, allowing to press against a surface of the panel 1 as wide as possible.

The gripping head 4 of the mechanical arm 2 is capable of applying pressure independently at various points on the panel 1, thereby reducing the amount of glass torn off during the removal of the aluminium frame 11.

The panel 1 is rotated by the same mechanical arm 2 via the end joint of the mechanical arm 2, optimizing the cycle time.

The panel 1 dimensional analysis makes it possible to adjust the positioning of the frame-removing means 3 even before the panel 1 is positioned in the frame-removal station, further optimizing the cycle time.

The torn off aluminium bars are collected in a hopper and discharged through a belt connected to the hopper.

The frame-removing means 3 have blades 6 whose end tends to tilt upwards once it comes into contact with the aluminium frame 11, allowing greater efficiency in the tearing-off step.

Once the frame has been removed, the panel 1 is unloaded via the belt carpet 7.

## Claims

1. Machine for removing a frame (11) from a photovoltaic panel (1), which panel (1) comprises a main body (10) and a frame (11) fixed perimetrically to the main body (10), comprising support means adapted to hold the panel (1) in a frame-removing position and frame-removing means (3) configured to press on part of the frame (11) when the panel (1) is held by the support means until causing the frame (11) to be removed from the main body (10),
**characterized in that**
the frame-removing means (3) are configured to act on two mutually opposite sides of said frame (11) and the support means comprise a gripping device (4) driven by drive means, which gripping device (4) is movable at least away from and towards the frame-removing means (3) and is rotatable at least around an axis perpendicular to the face of the panel (1) and is provided with a plurality of suction gripping members (5).

2. Machine according to Claim 1, wherein the support means comprise a mechanical arm (2), and the gripping device (4) consists of a gripping head of said mechanical arm (2).

3. Machine according to Claim 1 or 2, wherein each suction gripping member (5) is adapted to grip a respective gripping portion on the panel (1) and comprises an adjustable pusher element (50) configured to adjustably push said panel portion (1).

4. Machine according to Claim 3, wherein each pusher element (50) is actuatable independently with respect to the other pusher elements (50) and is configured to exert an autonomously adjustable pressure.

5. Machine according to one or more of the preceding claims, wherein a panel (1) dimensional analysis module is comprised.

6. Machine according to Claim 5, wherein said suction gripping members (5) are provided movable on the gripping device (4) and the gripping device (4) is provided with means for moving the suction gripping members (5).

7. Machine according to Claim 6, wherein the means for moving the suction gripping members (5) are configured to move the suction gripping members (5) as close as possible to the edges or corners of the panel (1) on the basis of the dimensions detected by said panel (1) dimensional analysis module.

8. Machine according to Claim 5 or 6 or 7, wherein the frame-removing means (3) are configured to be positioned preliminarily on the basis of the dimensions detected by said photovoltaic panel (1) dimensional analysis module and/or to adjust their excursion on the basis of the dimensions detected by said photovoltaic panel (1) dimensional analysis module.

9. Machine according to one or more of the preceding claims, wherein the frame-removing means (3) comprise blades of contact (6) with said frame (11), which blades (6) have a sharp engagement end edge (60) and an intermediate thrust surface (61) and are tiltable in a direction away from the surface of the panel in such a way that, during the action of the frame-removing means (3), the blades (6) carry out a prior insertion into the slot (12) between the frame (11) and the main body (10) by means of the sharp engagement end edge (60) and a subsequent thrust by means of said intermediate thrust surface (61).

10. Machine according to one or more of the preceding claims, wherein the support means comprise an abutment plate consisting of a plurality of movable sectors (9) driven independently of each other in such a way that they form two alternative configurations adapted to maximize the area of contact of the abutment plate with the panel (1) in orientations of the panel (1) perpendicular to each other.

11. Method for removing a frame (11) from a photovoltaic panel (1), which panel (1) comprises a main body (10) and a frame (11) fixed perimetrically to the main body (10),
**characterized in that**
it comprises the following steps:
a) withdrawing one said panel (1) by a mechanical arm (2) provided with a gripping head (4) comprising suction gripping members (5);
b) positioning the panel (1) near frame-removing means (3) by the mechanical arm (2);
c) simultaneous holding by said mechanical arm (2) in position of the panel (1) and actuation of the frame-removing means (3).

12. Method according to Claim 11, wherein each suction gripping member (5) grips a respective gripping portion on the panel (1) and comprises an adjustable pusher element (50) configured to adjustably push said panel portion (1).

13. Method according to Claim 12, wherein each pusher element (50) is actuatable independently with respect to the other pusher elements (50) and is configured to exert an autonomously adjustable pressure.

14. Method according to Claim 11, 12 or 13, wherein said suction gripping members (5) are provided movable on the gripping device (4).
